Europäisches Patentamt

European Patent Office

Office européen des brevets

(11) Veröffentlichungsnummer : **0 182 031**
**B1**

(12) **EUROPÄISCHE PATENTSCHRIFT**

(45) Veröffentlichungstag der Patentschrift :
06.07.88

(51) Int. Cl.⁴ : **G 03 F  3/10**

(21) Anmeldenummer : 85111801.8

(22) Anmeldetag : 18.09.85

(54) Verfahren zur Herstellung eines Mehrfarbenbilds.

(30) Priorität : 22.10.84 US 663608

(43) Veröffentlichungstag der Anmeldung :
28.05.86 Patentblatt 86/22

(45) Bekanntmachung des Hinweises auf die Patenterteilung : 06.07.88 Patentblatt 88/27

(84) Benannte Vertragsstaaten :
DE FR GB IT NL SE

(56) Entgegenhaltungen :
EP-A- 0 019 896
EP-A- 0 115 899
WO-A-81 /007 72
DE-A- 1 912 864
FR-A- 2 345 746

(73) Patentinhaber : HOECHST CELANESE CORPORA-
TION
Route 202-206 North
Somerville, N.J. 08876 (US)

(72) Erfinder : Platzer, Stephan J.
R.R. No. 1 Box 91
Wildwood Road Califon New Jersey 07830 (US)
Erfinder : Koletar, Gabor I.
212 Dogwood Lane
Berkeley Heights New Jersey 07922 (US)

(74) Vertreter : Euler, Kurt Emil, Dr.
HOECHST AG - Werk KALLE Patentabteilung Postfach 3540 Rheingaustrasse 190
D-6200 Wiesbaden (DE)

## Beschreibung

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster- oder Strichbildes sein und soll den Tonwert der Farben weder erhöht ·noch herabgesetzt wiedergeben. Die visuelle Farbprüfung soll folgendes aufzeigen :

1. Fehler in der Photomaske,
2. die beste Farbwiedergabe, die beim Drucken in der Druckmaschine von dem Material zu erwarten ist,
3. die genaue Gradation aller Farbtöne und ob die Grautöne neutral sind,
4. die eventuelle Notwendigkeit zur Abschwächung einer der Farben und/oder Hinweise zur Änderung der Filmvorlage vor der Herstellung der Druckplatten.

Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb alternative Farbprüfverfahren entwickelt, die den Andrucken in der Qualität gleichkommen sollen. Zwei photographische Farbprüfverfahren sind bekannt, nämlich das sogenannte Surprint-Verfahren (Übereinanderkopieren) und das sogenannte Overlay-Verfahren (Übereinanderlegen).

Beim Farbprüfen nach dem Overlay-Verfahren wird auf jeweils einem transparenten Kunststoffträger von jedem Farbauszug für sich ein Teilfarbenbild hergestellt. Zur Herstellung eines Farbprüfsatzes werden dann mehrere solcher mit Teilfarbenbildern versehener Träger übereinander auf ein weißes Blatt gelegt. Das Overlay-Verfahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von den Drucken unterscheidet, die man mit einem konventionellen Farbandruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturmaßnahmen dienen kann.

Bei der Prüfung nach dem Surprint-Verfahren wird ein Farbprüfbild angefertigt, indem nacheinander Bilder in verschiedenen Farben von verschiedenen Farbauszügen auf einem einzigen Empfangsblatt hergestellt werden. Dazu wird nur ein undurchsichtiger Träger verwendet, auf den nacheinander Toner oder lichtempfindliche Schichten in den entsprechenden Farben aufgebracht werden, wie es zum Beispiel in der US-A 3 671 236 beschrieben ist. Das Surprint-Verfahren hat den Vorteil, daß die Farbsättigung nicht durch übereinanderliegende Kunststoffträger beeinflußt wird. Dieses Verfahren kommt dem tatsächlichen Druck näher und vermeidet die dem Overlay-Verfahren eigene Farbverfälschung.

Aus den US-A 3 060 023, 3 060 024, 3 060 025, 3 481 736 und 3 607 264 sind verschiedene Verfahren zur Herstellung von Kopien eines Bildes durch Photopolymerisation und thermische Übertragung bekannt. Bei diesen Verfahren wird eine auf einen geeigneten Träger aufgebrachte photopolymerisierbare Schicht unter einer Transparentvorlage bildmäßig belichtet. Die Oberfläche der belichteten Schicht wird dann auf die Bildempfangsfläche eines separaten Empfangsblatts aufgelegt, angepreßt und auf eine Temperatur erwärmt, die höher ist als die Übertragungstemperatur der unbelichteten Schichtbereiche. Dann werden die beiden Träger voneinander getrennt, wobei die thermisch übertragbaren unbelichteten Bildstellen auf dem Bildempfangsmaterial verbleiben. Wenn diese Schichtteile nicht vorgefärbt sind, kann das klebrige unbelichtete Bild nun mit einem gewünschten Toner eingefärbt werden.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

In der EP-A 115 899 ist ein lichtempfindliches Material für die Herstellung von Farbprüffolien beschrieben, das auf einem Schichtträger eine positiv arbeitende lichtempfindliche Schicht mit einem Farbstoff und eine wärmeaktivierbare Klebstoffschicht trägt. Die Schichten werden auf ein Bildempfangsmaterial laminiert, belichtet und entwickelt. Dabei werden jeweils nur einzelne Teilfarbenbilder hergestellt und geprüft.

In der EP-A 19 896 werden im wesentlichen positiv arbeitende lichtempfindliche Farbprüffolien beschrieben, die für das Overlay-Verfahren geeignet sind. Eine Bild- oder Schichtübertragung findet hier nicht statt.

Aufgabe der Erfindung war es, ein Verfahren zur Herstellung eines Mehrfarbenbilds nach der Surprint-Technik vorzuschlagen, bei dem Negativ-Teilfarbenbilder auf ein gemeinsames Empfangsblatt übertragen oder auf diesem erzeugt werden, ohne daß ein gesondertes Aufbringen von Zwischenschich-

**0 182 031**

ten erforderlich ist.

Gegenstand der Erfindung ist ein Verfahren zur Herstellung eines Mehrfarbenbilds, bei dem ein lichtempfindliches Material aus einem temporären Schichtträger, einer lichtempfindlichen Schicht, die ein Bindemittel, ein Diazoniumsalz-Polykondensationsprodukt und einen Farbstoff oder ein Pigment einer bestimmten Grundfarbe enthält, und einer Haftschicht auf der lichtempfindlichen Schicht auf einen permanenten Schichtträger unter Druck und Erwärmen laminiert wird, wobei die Haftung der lichtempfindlichen Schicht an dem temporären Schichtträger geringer ist als die Haftung der Haftschicht an der lichtempfindlichen Schicht und an dem permanenten Schichtträger, die lichtempfindliche Schicht bildmäßig belichtet, der temporäre Schichtträger abgezogen und die belichtete Schicht durch Auswaschen der unbelichteten Bereiche entwickelt wird.

Das erfindungsgemäße Verfahren ist dadurch gekennzeichnet, daß die lichtempfindliche Schicht als Bindemittel ein Polyvinylbutyral und bzw. oder ein Styrol-Maleinsäurehalbester-Copolymeres und die Haftschicht ein Vinylacetatpolymeres enthält und einen Erweichungspunkt im Bereich von 60 bis 180 °C hat, daß man entweder

a) nach dem Laminieren zuerst den temporären Schichtträger abzieht und danach die lichtempfindliche Schicht bildmäßig belichtet oder

b) nach dem Laminieren zuerst die lichtempfindliche Schicht belichtet und danach den temporären Schichtträger abzieht oder

c) zuerst die lichtempfindliche Schicht belichtet, dann das belichtete lichtempfindliche Material auf den permanenten Schichtträger laminiert und schließlich den temporären Schichtträger abzieht, daß man die Entwicklung der belichteten lichtempfindlichen Schicht bei einer Temperatur durchführt, bei der die Haftschicht nicht klebrig ist, und daß man die vorstehenden Schritte mindestens einmal mit einem lichtempfindlichen Material wiederholt, das einen Farbstoff oder ein Pigment in einer anderen Grundfarbe enthält, wobei das zweite lichtempfindliche Material auf das erste entwickelte Teilfarbenbild laminiert wird.

Zur Durchführung des erfindungsgemäßen Verfahrens wird ein lichtempfindliches Material eingesetzt, das generell aus einem temporären Träger mit einer wenig haftenden Oberfläche, einer farbigen lichtempfindlichen Schicht auf der Oberfläche und einer Haft- bzw. Klebeschicht auf der lichtempfindlichen Schicht besteht. Gegebenenfalls können auch noch weitere Schichten verwendet werden, die Lichthofschutzmittel, Haftvermittler oder Trennmittel enthalten.

In bevorzugter Ausführung besteht der Träger aus einer maßbeständigen und chemisch stabilen Polyesterfolie, insbesondere aus Polyethylenterephthalat, die normalerweise eine Dicke von etwa 25-250 μm, vorzugsweise etwa 50-130 μm und insbesondere etwa 50-75 μm aufweist. Geeignete Folien sind zum Beispiel Hostaphan 3000 (Hersteller American Hoechst Corporation), Mylar D (Hersteller DuPont) und Melinex in den Qualitäten 0, 052, 442, 516 und S (Hersteller ICI). Die Oberfläche des Trägers kann glatt sein, oder sie kann nach verschiedenen bekannten Verfahren mit einer matten Struktur versehen werden.

Als matte Folien sind zum Beispiel Melinex 377 und 470 von ICI geeignet. Diese Materialien haben die Eigenschaft, daß sie dem endgültigen Bild ohne zusätzliche Arbeitsgänge die gewünschte Mattigkeit verleihen. Der Glanz des endgültigen Bildes kann durch die richtige Wahl der matten Oberflächenstruktur des temporären Trägers gesteuert werden. Dieser Effekt wird erreicht, weil die oberste Schicht des endgültigen Bildes ursprünglich mit der matten Oberfläche in Berührung war. Wenn sich zwischen dem temporären Träger und der lichtempfindlichen Schicht eine besondere Trennschicht befindet, ist das nicht der Fall. Die Verwendung einer Folie mit matter Oberfläche hat außerdem den Vorteil, daß später übertragene Schichten im allgemeinen besser auf einer rauhen als auf einer glatten Oberfläche haften.

Eine ähnliche Mattierung des endgültigen Bildes kann durch Prägen der glänzenden Bildoberfläche mit Hilfe einer matten Folie erreicht werden. Dazu werden das endgültige Bild und die Folie unter Druck und Erwärmen aufeinander laminiert. Im allgemeinen wird die Folie nach dem Laminieren wieder entfernt. Dieses Verfahren hat den Vorteil, daß die Oberflächenbeschaffenheit des fertigen Prüfsatzes variiert werden kann. Außerdem kann die Mattierungsfolie mehrmals verwendet werden.

In einem dritten Verfahren zur Herstellung einer Mattierung wird eine in der Wärme übertragbare Klebeschicht, zum Beispiel Butvar 90 (Polyvinylbutyral ; Hersteller Monsanto), auf eine Folie mit rauher Oberfläche, zum Beispiel Melinex 329 (Hersteller ICI) aufgebracht. Die Folie mit rauher Oberfläche wird mit der Seite der Klebeschicht unter Druck und Erwärmen auf das endgültige Bild laminiert und anschließend wieder abgezogen. Die rauhe Oberfläche der Folie bewirkt eine Mattierung des endgültigen Bildes. Das Verfahren hat den Vorteil, daß alle Schichten matt erscheinen und daß die zusätzliche Klebeschicht das Bild schützt. Verschiedene Verfahren zur Herstellung einer matten Oberfläche sind weiterhin in den US-A 4 294 909 und 4 376 159 vorgeschlagen.

In jedem Fall muß der Träger eine mäßig haftende Oberfläche aufweisen, d. h. die lichtempfindliche Schicht muß von ihm wieder abgetrennt werden können. Zu diesem Zweck kann entweder die Trägeroberfläche von ihrer Natur her wenig haften ; die Haftung kann durch eine geeignete Behandlung herabgesetzt werden, oder der Träger kann mit einer Ablöseschicht versehen werden. Eine derartige Ablöseschicht kann eine Schicht auf Basis von Polyvinylalkohol sein.

Die lichtempfindliche Schicht ist also trennbar mit dem Träger verbunden. Im allgemeinen besteht

3

die lichtempfindliche Schicht aus dem Photosensibilisator, einem Farbmittel, einem Harz als Bindemittel und gegebenenfalls weiteren Bestandteilen, z. B. Weichmachern, sauren Stabilisatoren, Tensiden, Antistatika, UV-Absorbern und Lösemittelresten.

Als Photosensibilisator wird ein Diazoniumsalz-Polykondensationsprodukt verwendet. Der am meisten bevorzugte Photosensibilisator ist das Polykondensationsprodukt aus 3-Methoxy-diphenylamin-4-diazoniumsulfat und 4,4'-Bis-methoxymethyl-diphenylether, ausgefällt als Mesitylensulfonat, wie in der US-A 3 849 392 beschrieben: Weitere geeignete Photosensibilisatoren sind in der US-A 4 436 804 genannt. Die gewählten Diazoniumverbindungen sind bevorzugt in organischen Lösemitteln löslich.

Als Bindemittel geeignete Harze sind Polyvinylbutyral und Styrol/Maleinsäurehalbester-Copolymeren oder Mischungen daraus. Solche Harze sind beispielsweise Butvar B 72, B 76 und B 90 und Scripset 540 bzw. 550, die alle von Monsanto hergestellt werden. Ein wichtiges Kriterium bei der Wahl des Harzes ist, daß es gute Filmbildungseigenschaften haben muß.

Zu den erfindungsgemäß geeigneten Farbmitteln zählen verschiedene Farbstoffe und Pigmente. In der am meisten bevorzugten Ausführung werden Pigmente mit einer durchschnittlichen Teilchengröße von höchstens etwa 1 µm eingesetzt.

Der lichtempfindlichen Schicht können gegebenenfalls Weichmacher vom Phthalat- oder Phosphattyp zugesetzt werden. Bevorzugte Weichmacher sind Dibutylphthalat und Dimethylphthalat. Geeignete saure Stabilisatoren sind zum Beispiel Phosphorsäure und p-Toluolsulfonsäure.

Diese Komponenten können in verträglichen Lösemitteln wie Ethanol, 2-Methoxy-ethanol oder Butanon gelöst auf die Trennfläche aufgetragen und getrocknet werden. In bevorzugter Ausführung hat die lichtempfindliche Schicht ein Schichtgewicht zwischen etwa 0,1 und 5,0 g/m². Das Schichtgewicht liegt insbesondere zwischen 0,5 und 2,0 g/m².

Vorzugsweise sind die Komponenten in folgenden Anteilen in der lichtempfindlichen Schicht enthalten : der Photosensibilisator von etwa 5-40 Gew.-%, insbesondere von etwa 10-35 Gew.-%, das Farbmittel von etwa 10-40 Gew.-%, insbesondere von etwa 13-34 Gew.-%, das Bindemittel von etwa 25-80 Gew.-%, insbesondere von etwa 32-75 Gew.-%, der gegebenenfalls verwendete Weichmacher bis zu etwa 20 Gew.-%, vorzugsweise bis zu etwa 15 Gew.-% und insbesondere von etwa 12 bis 15 Gew.-%, und der gegebenenfalls verwendete saure Stabilisator bis zu etwa 10 Gew.-%.

Nachfolgend sind zwei typische Zusammensetzungen für die lichtempfindlichen Schichten angegeben :

| I. | Cyan | Gelb | Schwarz |
|---|---|---|---|
| 2-Methoxy-ethanol | 27,37 | 62,16 | 58,35 |
| Butanon | 40,30 | 33,00 | 35,65 |
| Ethanol | 27,20 | - | - |
| konz. Phosphorsäure | 0,40 | - | 0,50 |
| p-Toluolsulfonsäure | - | 0,25 | - |
| Dibutylphthalat | - | - | 0,75 |
| Butvar 72 | 1,08 | 1,62 | 1,125 |
| Butvar 90 | 0,60 | 0,80 | 1,50 |
| Diazoniumverbindung +) | 1,70 | 0,55 | 1,00 |
| Phthalocyaninblau | 1,35 | - | - |
| gelbes Pigment | - | 1,62 | - |
| schwarzes Pigment | - | - | 1,125 |
| optische Dichte | 1,2 | 0,9 | 1,3 |

+) Polykondensationsprodukt aus 3-Methoxy-diphenylamin-4-diazoniumsalz und 4,4'-Bis-methoxymethyl-diphenylether

| II. | Cyan | Gelb | Magenta | Schwarz |
|---|---|---|---|---|
| 2-Methoxy-ethanol | 41,00 | 41,00 | 46,50 | 41,00 |
| Butanon | 41,00 | 40,99 | 46,48 | 41,00 |
| $\gamma$-Butyrolacton | 10,00 | 10,00 | - | 10,00 |
| Dimethylphthalat | 0,75 | 0,75 | 0,88 | 0,75 |

4

(Fortsetzung)

| II. | Cyan | Gelb | Magenta | Schwarz |
|---|---|---|---|---|
| Dibutylphthalat | 0,25 | 0,25 | - | 0,25 |
| p-Toluolsulfonsäure | - | - | 0,18 | 0,35 |
| Scripset 540 | 3,33 | 2,60 | 3,15 | 3,71 |
| Scripset 550 | 1,17 | - | - | - |
| hydrolysiertes Scripset 540 | - | - | 0,67 | - |
| SMA 2625 | - | 2,02 | - | - |
| Diazoniumverbindung wie bei I | 1,33 | 1,35 | 0,70 | 2,00 |
| Phthalocyaninblau | 1,17 | - | - | - |
| gelbes Pigment | - | 1,04 | - | - |
| Magentapigment | - | - | 1,44 | - |
| schwarzes Pigment | - | - | - | 0,94 |
| optische Dichte | 1,1 | °0,9 | 1,2 | 1,5 |

Scripset und SMA sind handelsübliche Styrol/Maleinsäurepartialester-Copolymere.

Die Haftschicht besteht aus Polyvinylacetat. Sie kann gegebenenfalls weitere gewünschte Komponenten, wie UV-Absorber, Antistatika und Weichmacher enthalten. Beispiele für geeignete Polyvinylacetate sind Mowilith 20, 25, 30, DM 6, DM 22 und Mischungen daraus (Hersteller Hoechst AG). Die Polyvinylacetate werden gewöhnlich in Wasser dispergiert oder in einem organischen Lösemittel gelöst und auf die lichtempfindliche Schicht aufgebracht. Die Schicht wird dann getrocknet, so daß sich ein Schichtgewicht von etwa 5-30 g/m², bevorzugt von etwa 10 bis 20 g/m² ergibt. In der Schicht können gegebenenfalls ein UV-Absorber, z. B. Uvinul D-50 (Hersteller GAF), ein Weichmacher, z. B. Resoflex R-296 (Hersteller Cambridge Industries) sowie Antistatika, z. B. Gafac und Gafstat (Hersteller GAF) und weitere Harze, z. B. Nitrocellulose R 1/2 (Hersteller Hercules) enthalten sein.

Während der Lagerung oder Entwicklung des lichtempfindlichen Elements soll sich die Haftschicht nicht klebrig anfühlen. Die Schicht soll einen Erweichungspunkt im Bereich von etwa 60-180 °C, vorzugsweise von 60-120 °C, insbesondere von 60-100 °C, haben. In bevorzugter Ausführung ist das Polyvinylacetat in einem Anteil von mehr als 50 Gew.-% in der Haftschicht enthalten. Der Weichmacher kann in einem Anteil von bis zu etwa 30 Gew.-%, der UV-Absorber bis zu etwa 20 Gew.-% und andere Harze bis weniger als 50 Gew.-% in der Schicht anwesend sein.

Die Haftschicht kann zum Beispiel eine der folgenden Zusammensetzungen (Gew.-%) haben :

| I. Wasser | 50 |
|---|---|
| Mowilith DM-22 | 50 |

| II. n-Butylacetat | 78 |
|---|---|
| Resoflex R-296 | 1 |
| Mowilith 25 | 21 |

| III. n-Butylacetat | 68,7 |
|---|---|
| Uvinul D-50 | 1,3 |
| Mowilith 20 | 30,0 |

Bei der praktischen Anwendung wird das lichtempfindliche Material mit der Haftschicht auf ein Empfangsblatt laminiert. Das Empfangsblatt soll beständig gegen irgendwelche Beeinträchtigungen durch den gewählten Entwickler sein. Bei Verwendung von wäßrigen Entwicklern soll es zum Beispiel wasserfest sein. Für diesen Zweck sind Kunststoff- oder kunststoffbeschichtete Empfangsblätter geeignet.

Als Empfangsmaterialien geeignete Folien sind zum Beispiel Melinex 329, 339, 994 und 3020 von ICI. Es können aber auch andere weiße und nicht-weiße Empfangsmaterialien verwendet werden. Die Oberfläche des Empfangsmaterials hat vorzugsweise eine rauhe Struktur und/oder ist haftvermittelnd behandelt worden, und sie muß unempfindlich gegen die Laminier- und Entwicklungsvorgänge sein.

Das Laminieren kann so durchgeführt werden, daß das Empfangsblatt mit der Haftschicht des farbigen Materials in Kontakt gebracht wird und dann beide Materialien unter entsprechendem Druck zusammen durch den Walzenspalt eines beheizten Laminierwalzenpaares geführt werden. Geeignete Laminiertemperaturen liegen im allgemeinen bei etwa 60-90 °C, vorzugsweise bei 75-85 °C. Nach dem Laminieren wird der Träger abgezogen, was normalerweise einfach von Hand geschieht. Die Haftschicht und die lichtempfindliche Schicht bleiben dabei auf dem Empfangsblatt zurück.

Die lichtempfindliche Schicht wird entweder vor oder nach dem Laminieren in bekannter Weise bildmäßig belichtet. Sie kann z. B. mit einer UV-Lichtquelle durch eine Photomaske im Vakuumkopierrahmen belichtet werden. Damit die Schichten bei der Belichtung miteinander im Kontakt sind, wird vorzugsweise nach dem Laminieren und Abziehen der Trägerfolie belichtet. Quecksilberdampflampen werden gegenüber Metallhalogenidlampen bevorzugt. Es können auch Filter verwendet werden, um die Lichtstreuung zu reduzieren.

Nach dem Laminieren, Abziehen der Trägerfolie und Belichten wird die lichtempfindliche Schicht entwickelt, indem die nichtbelichteten Bereiche in einem geeigneten Entwickler abgelöst werden. Anschließend wird getrocknet. Die Haftschicht wird beim Entwickeln nicht entfernt. Geeignete Entwickler sind zum Beispiel :

|   |   |
|---|---|
| I. Wasser | 95,0 |
| Natriumdecylsulfat | 3,0 |
| Dinatriumphosphat | 1,5 |
| Natriummetasilicat | 0,5 |
|   |   |
| II. Wasser | 89,264 |
| Mononatriumphosphat | 0,269 |
| Trinatriumphosphat | 2,230 |
| Natriumtetradecylsulfat | 8,237 |

Der Vorgang kann dann wiederholt werden, wobei ein weiteres lichtempfindliches Material in einer anderen Farbe über das zuvor hergestellte Bild auf dasselbe Empfangsblatt laminiert wird. Um die komplette Farbwiedergabe eines gewünschten Bildes zu erhalten, werden normalerweise vier farbige Schichten verwendet. Diese Farbschichten umfassen Cyan (Blaugrün), Magenta (Purpur), Gelb und Schwarz.

Die Erfindung wird durch das folgende Beispiel näher erläutert.

Beispiel

Es werden vier lichtempfindliche Lösungen in den Farben Blaugrün, Gelb, Purpur und Schwarz nach der oben angegebenen Rezeptur II für die lichtempfindlichen Lösungen hergestellt. Das Pigment wird der Lösung jeweils in Form einer Dispersion aus Butanon, Scripset 540 und dem entsprechenden Pigment zugegeben. Die Lösungen werden einzeln auf 75 μm dicke Polyesterfolien (Melinex 516) als temporäre Träger so aufgebracht und getrocknet, daß sich die erforderliche optische Dichte ergibt. Die Schichtgewichte betragen ungefähr 1,3 g/m² für Blaugrün, 0,9 g/m² für Gelb, 1,8 g/m² für Purpur und 1,2 g/m² für Schwarz. Die Kleberlösung, insbesondere nach der oben angegebenen Kleberrezeptur II, wird auf die lichtempfindliche Schicht aufgebracht und zu einem Schichtgewicht von 12 g/m² getrocknet. Das gelbe Material wird dann bei 80 °C mit der Haftschicht nach Belieben auf eine der beiden Seiten eines 180 μm dicken Polyesterempfangsblattes (Melinex 3020) laminiert. Der temporäre Träger (Melinex 516) wird nach dem Laminieren abgezogen, wobei die Haftschicht und die lichtempfindliche Schicht auf dem Empfangsblatt verbleiben. Die gelbe lichtempfindliche Schicht wird dann unter dem Auszug für die gelbe Farbe belichtet. Das Empfangsblatt mit der belichteten gelben Schicht wird bei 27 °C 15 Sekunden in den oben genannten Entwickler II getaucht und dabei auf der lichtempfindlichen Seite leicht gerieben. Die nichtbelichteten gelben Bereiche werden beim Entwickeln abgelöst, die belichteten Bereiche bleiben zurück.

Die Haftschicht wird durch den Entwickler nicht angegriffen. Nach dieser Behandlung wird das bebilderte Material abgespült und getrocknet. Das purpurfarbene Material wird dann wie oben beschrieben auf die bebilderte gelbe Seite des Empfangsblattes laminiert und der temporäre Träger abgezogen. Anschließend wird die purpurfarbene Schicht durch den entsprechenden Farbauszug belichtet und wie die gelbe Schicht verarbeitet. Auf Purpur folgen in gleicher Weise Blaugrün und dann Schwarz, so daß man schließlich ein Vierfarbenbild erhält, das eine genaue Wiedergabe des Originals ist, von dem die Farbauszüge hergestellt wurden.

**Patentansprüche**

1. Verfahren zur Herstellung eines Mehrfarbenbilds, bei dem ein lichtempfindliches Material aus einem temporären Schichtträger, einer lichtempfindlichen Schicht, die ein Bindemittel, ein Diazoniumsalz-Polykondensationsprodukt und einen Farbstoff oder ein Pigment einer bestimmten Grundfarbe enthält, und einer Haftschicht auf der lichtempfindlichen Schicht auf einen permanenten Schichtträger unter Druck und Erwärmen laminiert wird, wobei die Haftung der lichtempfindlichen Schicht an dem temporären Schichtträger geringer ist als die Haftung der Haftschicht an der lichtempfindlichen Schicht und an dem permanenten Schichtträger, die lichtempfindliche Schicht bildmäßig belichtet, der temporäre Schichtträger abgezogen und die belichtete Schicht durch Auswaschen der unbelichteten Bereiche entwickelt wird, dadurch gekennzeichnet, daß die lichtempfindliche Schicht als Bindemittel ein Polyvinylbutyral und bzw. oder ein Styrol-Maleinsäurehalbester-Copolymeres und die Haftschicht ein Vinylacetatpolymeres enthält und einen Erweichungspunkt im Bereich von 60 bis 180 °C hat, daß man entweder

    a) nach dem Laminieren zuerst den temporären Schichtträger abzieht und danach die lichtempfindliche Schicht bildmäßig belichtet oder

    b) nach dem Laminieren zuerst die lichtempfindliche Schicht belichtet und danach den temporären Schichtträger abzieht oder

    c) zuerst die lichtempfindliche Schicht belichtet, dann das belichtete lichtempfindliche Material auf den permanenten Schichtträger laminiert und schließlich den temporären Schichtträger abzieht, daß man die Entwicklung der belichteten lichtempfindlichen Schicht bei einer Temperatur durchführt, bei der die Haftschicht nicht klebrig ist, und daß man die vorstehenden Schritte mindestens einmal mit einem lichtempfindlichen Material wiederholt, das einen Farbstoff oder ein Pigment in einer anderen Grundfarbe enthält, wobei das zweite lichtempfindliche Material auf das erste entwickelte Teilfarbenbild laminiert wird.

2. Verfahren nach Anspruch 1, dadurch gekennzeichnet, daß der temporäre Schichtträger ein transparenter Polyesterfilm ist.

3. Verfahren nach Anspruch 1, dadurch gekennzeichnet, daß der temporäre Schichtträger eine mattierte Oberfläche hat.

4. Verfahren nach Anspruch 1, dadurch gekennzeichnet, daß das Gewicht der lichtempfindlichen Schicht 0,1 bis 5 g/m$^2$ beträgt.

5. Verfahren nach Anspruch 1, dadurch gekennzeichnet, daß die lichtempfindliche Schicht 10 bis 40 Gew.-% Farbstoff oder Pigment enthält.

6. Verfahren nach Anspruch 1, dadurch gekennzeichnet, daß die lichtempfindliche Schicht 5 bis 40 Gew.-% Diazoniumsalz-Polykondensationsprodukt enthält.

7. Verfahren nach Anspruch 1, dadurch gekennzeichnet, daß die lichtempfindliche Schicht 25 bis 80 Gew.-% Bindemittel enthält.

**Claims**

1. A method of producing a multicolor image, in which a light-sensitive material composed of a temporary base material, a light-sensitive layer containing a binder, a diazonium salt polycondensation product and a dye or a pigment of a certain primary color, and an adhesion-promoting layer on the light-sensitive layer is laminated onto a permanent base material by pressing and heating, the adhesion of the light-sensitive layer to the temporary base material being less than the adhesion of the adhesion-promoting layer to the light-sensitive layer and to the permanent base material, the light-sensitive layer being subjected to imagewise exposure, the temporary base material being peeled off, and the exposed layer being developed by washing out of the unexposed areas, wherein the light-sensitive layer contains as the binder a polyvinyl butyral and/or a styrene/maleic monoester copolymer and the adhesion-promoting layer contains a vinyl acetate polymer and has a softening point within the range from 60 to 180 °C, and either

    a) after lamination first the temporary base material is peeled off and then the light-sensitive layer is subjected to imagewise exposure or

    b) after lamination first the light-sensitive layer is subjected to exposure and then the temporary base material is peeled off or

    c) first the light-sensitive layer is subjected to exposure, then the exposed light-sensitive material is laminated onto the permanent base material and finally the temporary base material is peeled off, the development of the exposed light-sensitive layer is carried out at a temperature at which the adhesion-promoting layer is not tacky, and the preceding steps are repeated at least once with a light-sensitive material which contains a dye or a pigment in another primary color, the second light-sensitive material being laminated onto the first developed separation image.

2. The method as claimed in claim 1, wherein the temporary base material is a transparent polyester film.

3. The method as claimed in claim 1, wherein the temporary base material has a matted surface.

4. The method as claimed in claim 1, wherein the weight of the light-sensitive layer is 0.1 to 5 g/m$^2$.

5. The method as claimed in claim 1, wherein the light-sensitive layer contains 10 to 40 % by weight of dye or pigment.

6. The method as claimed in claim 1, wherein the light-sensitive layer contains 5 to 40 % by weight of diazonium salt polycondensation product.

7. The method as claimed in claim 1, wherein the light-sensitive layer contains 25 to 80 % by weight of binder.

**Revendications**

1. Procédé pour réaliser une image polychrome, selon lequel on dépose en superposition, sur un support de couche permanent, moyennant l'application de pression et de chauffage, un matériau photosensible constitué par un support de couche temporaire, par une couche photosensible, — qui contient un liant, un produit de polycondensation d'un sel de diazonium et un colorant ou un pigment possédant une couleur de base déterminée.—, et par une couche adhésive située sur la couche photosensible, l'adhérence de la couche photosensible au support de couche temporaire étant inférieure à l'adhérence de la couche adhésive à la couche photosensible et au support de couche permanent, on expose la couche photosensible conformément à l'image, on retire le support de couche temporaire et on développe la couche exposée au moyen d'un enlèvement par lavage des zones non exposées, caractérisé en ce que la couche photosensible contient, en tant que liant, un polyvinylbutyral et/ou un copolymère de styrène/hémi-ester de l'acide maléique, et la couche adhésive contient un polymère d'acétate de vinyle et possède un point de ramollissement situé dans la gamme comprise entre 60 et 180 °C, et que

a) soit, après le dépôt en superposition, on retire tout d'abord le support de couche temporaire et on expose ensuite la couche photosensible, conformément à l'image,

b) soit, après le dépôt en superposition, on expose tout d'abord la couche photosensible et on retire ensuite le support de couche temporaire,

c) soit on expose tout d'abord la couche photosensible, puis on dépose le matériau photosensible exposé sur le support de couche permanent et on retire enfin le support de couche temporaire, et qu'on exécute le développement de la couche photosensible exposée à une température pour laquelle la couche adhésive n'est pas collante, et qu'on répète les étapes opératoires précédentes au moins une fois avec un matériau photosensible, qui contient un colorant ou un pigment dans une autre couleur de base, le second matériau photosensible étant déposé sur la première image développée, partiellement colorée.

2. Procédé selon la revendication 1, caractérisé en ce que le support de couche temporaire est un film de polyester transparent.

3. Procédé selon la revendication 1, caractérisé en ce que le support de couche temporaire est une surface mate.

4. Procédé selon la revendication 1, caractérisé en ce que le poids de la couche photosensible est compris entre 0,1 et 5 g/m$^2$.

5. Procédé selon la revendication 1, caractérisé en ce que la couche photosensible contient 10 à 40 % en poids d'un colorant ou d'un pigment.

6. Procédé selon la revendication 1, caractérisé en ce que la couche photosensible contient 5 à 40 % en poids d'un produit de polycondensation d'un seul de diazonium.

7. Procédé selon la revendication 1, caractérisé en ce que la couche photosensible contient 25 à 80 % en poids d'un liant.